# EUROPEAN PATENT APPLICATION

(11) **EP 4 561 311 A1**
(43) Date of publication of application: **28.05.2025**
(21) Application number: 24194100.4
(22) Date of filing: 12.08.2024
(51) Int. Cl.: H10K 50/856, H10K 59/35, H10K 59/80

(54) **DISPLAY PANEL AND ELECTRONIC DEVICE INCLUDING SAME**

(30) Priority: 21.11.2023 KR 20230161956
(71) Applicant: LG Display Co., Ltd., Seoul 07336 (KR)
(72) Inventor: YU, Un Sang, 10845 Paju-si, Gyeonggi-do (KR); KWAK, Bong Choon, 10845 Paju-si, Gyeonggi-do (KR)
(74) Representative: Viering, Jentschura & Partner mbB Patent- und Rechtsanwälte

(57) **Abstract**

A display panel and an electronic device including the same are disclosed. A display panel includes metal layers (M4), a first insulating layer (22) covering the metal layers (M4), a first reflective layer (35) on the first insulating layer (22) of a first sub-pixel (SP1), a second insulating layer (24) covering the first reflective layer (35), a second reflective layer (36) on the second insulating (24) layer of a second sub-pixel (SP2), a third insulating layer (26) covering the second reflective layer (36), a third reflective layer (37) on the third insulating layer (26) of a third sub-pixel (SP3), and first electrodes (32) on the third insulating layer (26) of each of the first to third sub-pixels (SP1, SP2, SP3). A plurality of holes (H) penetrating the first to third insulating layers (22, 24, 26) of each of the first to third sub-pixels (SP1, SP2, SP3) is formed, and the metal layer (M4) of each of the first to third sub-pixels (SP1, SP2, SP3) is coupled to the first electrode (32) of each of the first to third sub-pixels (SP1, SP2, SP3) through each hole (H).

## Description

### CROSS-REFERENCE TO RELATED APPLICATION

This application claims priority to and the benefit of Korean Patent Application No. 10-2023-0161956, filed November 21, 2023.

### BACKGROUND

### Technical Field

The present disclosure relates to relates to a display panel and an electronic device including the same.

### Description of Related Art

Recently, there has been a growing interest in organic light-emitting display devices with high-resolution for augmented reality (AR) and virtual reality (VR) electronics. Since AR/VR electronic devices require high frame rates and short duty cycle ratios for vivid descriptions, it is necessary to have high brightness operation characteristics in a short time.

Accordingly, organic light-emitting display devices with an OLED on silicon (OLEDoS) structure are being applied to AR/VR electronic devices. The organic light-emitting display devices with an OLEDoS structure may be implemented by forming organic light-emitting elements on a backplane using silicon wafers.

### BRIEF SUMMARY

In the process of manufacturing OLEDoS for these AR/VR electronic devices, metals that act as reflectors are stacked in a structure to amplify specific wavelengths for each R, G, and B pixel, but process simplification is essential due to the increase in wafer and mask costs and the increase in process tact time due to the increase in the number of layers added to improve luminance.

The present disclosure is directed to solving all the above-described necessity and problems.

The present disclosure provides a display panel and an electronic device including the same.

It should be noted that objects of the present disclosure are not limited to the above-described objects, and other objects of the present disclosure will be apparent to those skilled in the art from the following descriptions. According to an aspect of the present disclosure, a display panel according to claim 1 is provided. Further embodiments are described in the dependent claims.

A display panel according to embodiments of the present disclosure may include a plurality of metal layers formed on each of a first sub-pixel, a second sub-pixel, and a third sub-pixel; a first insulating layer covering the plurality of metal layers; a first reflective layer formed on an upper portion of the first insulating layer of the first sub-pixel; a second insulating layer covering the first reflective layer; a second reflective layer formed on the second insulating layer of the second sub-pixel; a third insulating layer covering the second reflective layer; a third reflective layer formed on the third insulating layer of the third sub-pixel; and a plurality of first electrodes formed on the third insulating layer of each of the first to third sub-pixels, wherein a plurality of holes penetrating the first to third insulating layers of each of the first to third sub-pixels is formed, and the metal layer of each of the first to third sub-pixels is electrically connected to the first electrode of each of the first to third sub-pixels through a respective hole of the plurality of holes.

A display panel according to embodiments of the present disclosure may include a metal layer; a first insulating layer covering the metal layer; a first reflective layer formed on an upper portion of the first insulating layer; a second insulating layer covering the first reflective layer; a second reflective layer formed on an upper portion of the second insulating layer; a third insulating layer covering the second reflective layer; a third reflective layer formed on an upper portion of the third insulating layer; and a first electrode formed on an upper portion of the third insulating layer, wherein a hole penetrating the first to third insulating layers is formed, and the metal layer is electrically connected to the first electrode through the hole.

According to the present disclosure, processes for forming vias may be reduced by sequentially stacking a plurality of reflective layers and an insulating layer and then forming a via for electrically connecting the plurality of reflective layers.

A development schedule may be shortened because the via processes are reduced to shorten a process tact time.

Manufacturing costs may be reduced by reducing the number of masks and wafers used in the via process.

The process of forming the via may be simplified, allowing for process optimization.

The effects of the present specification are not limited to the above-mentioned effects, and other effects that are not mentioned will be apparently understood by those skilled in the art from the following description and the appended claims.

### BRIEF DESCRIPTION OF THE SEVERAL VIEWS OF THE DRAWINGS

The above and other objects, features, and advantages of the present disclosure will become more apparent to those of ordinary skill in the art by describing exemplary embodiments thereof in detail with reference to the attached drawings, in which:
FIG. 1 is a plan view illustrating a pixel of a display panel according to an embodiment of the present disclosure;
FIG. 2 is a cross-sectional view schematically illustrating an example of a cross-sectional structure of a pixel taken along the line 'I-I' of FIG. 1 in a top emission type display panel;
FIG. 3 is a cross-sectional view schematically showing an example of a cross-sectional structure of a pixel taken along the line 'I-I' of FIG. 1 in a bottom emission type display panel;
FIG. 4 is a diagram illustrating a circuit of a sub-pixel included in the display panel shown in FIG. 1;
FIG. 5 is a cross-sectional view illustrating a display panel including the sub-pixel shown in FIG. 4;
FIG. 6 is a diagram illustrating a structure of a circuit layer according to a first embodiment of the present disclosure;
FIG. 7 is a diagram for explaining a structure and function of a residual reflective layer shown in FIG. 6;
FIG. 8 is a diagram illustrating a modified embodiment of the circuit layer shown in FIG. 6;
FIG. 9 is a diagram for explaining a principle of connection between reflective layers illustrated in FIG. 6;
FIG. 10 is a diagram illustrating a structure of a circuit layer according to a second embodiment of the present disclosure;
FIG. 11 is a diagram for explaining a principle of connection between reflective layers illustrated in FIG. 10;
FIG. 12 is a diagram illustrating a structure of a circuit layer according to a third embodiment of the present disclosure;
FIG. 13 is a diagram for explaining a principle of connection between reflective layers illustrated in FIG. 12.
FIG. 14 is a diagram illustrating a structure of a circuit layer according to a fourth embodiment of the present disclosure;
FIG. 15 is a diagram for explaining a principle of connection between reflective layers illustrated in FIG. 14;
FIG. 16 is a diagram illustrating an example of an appearance of an HMD-type personal immersive device; and
FIG. 17 is a block diagram illustrating an example of a display device applicable to a personal immersive device.

### DETAILED DESCRIPTION

Advantages and features of the present specification and methods of achieving them will become apparent with reference to preferable embodiments, which are described in detail, in conjunction with the accompanying drawings. However, the present specification is not limited to the embodiments to be described below and may be implemented in different forms, the embodiments are only provided to completely disclose the present disclosure and completely convey the scope of the present disclosure to those skilled in the art, and the present specification is defined by the disclosed claims.

The shapes, sizes, ratios, angles, numbers, and the like illustrated in the accompanying drawings for describing the embodiments of the present disclosure are merely examples, and the present disclosure is not limited thereto. Like reference numerals generally denote like elements throughout the present specification. Further, in describing the present disclosure, detailed descriptions of known related technologies may be omitted to avoid unnecessarily obscuring the subject matter of the present disclosure.

When 'including,' `having,' 'consisting,' and the like mentioned in the present specification are used, other parts may be added unless 'only' is used. A case in which a component is expressed in a singular form includes a plural form unless explicitly stated otherwise.

When it is mentioned that a first element "is connected or coupled to", "contacts or overlaps" etc. a second element, it should be interpreted that, not only can the first element "be directly connected or coupled to" or "directly contact or overlap" the second element, but a third element can also be "interposed" between the first and second elements, or the first and second elements can "be connected or coupled to", "contact or overlap", etc. each other via a fourth element. Here, the second element may be included in at least one of two or more elements that "are connected or coupled to", "contact or overlap", etc. each other.

In interpreting the components, it should be understood that an error range is included even when there is no separate explicit description.

In the case of a description of a positional relationship, for example, when the positional relationship of two parts is described as 'on,' `at an upper portion,' `at a lower portion,' `next to, and the like, one or more other parts may be located between the two parts unless `immediately' or 'directly' is used.

Although first, second, and the like are used to describe various components, these components are not limited by these terms. These terms are only used to distinguish one component from another. Accordingly, a first component, which is mentioned, below may also be a second component within the technical spirit of the present disclosure.

The same reference numerals may refer to substantially the same elements throughout the present disclosure.

The following embodiments can be partially or entirely bonded to or combined with each other and can be linked and operated in technically various ways. The embodiments can be carried out independently of or in association with each other.

Hereinafter, various embodiments of the present disclosure will be described in detail with reference to the accompanying drawings.

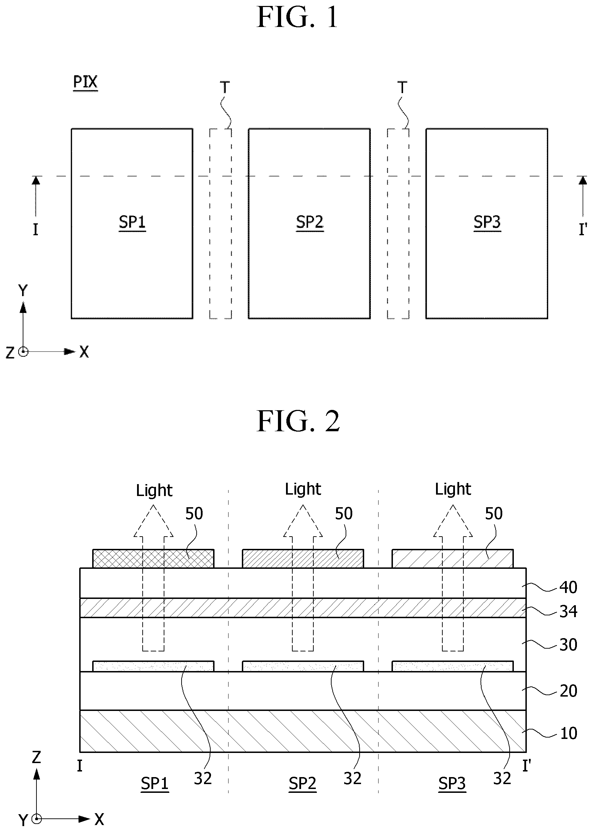

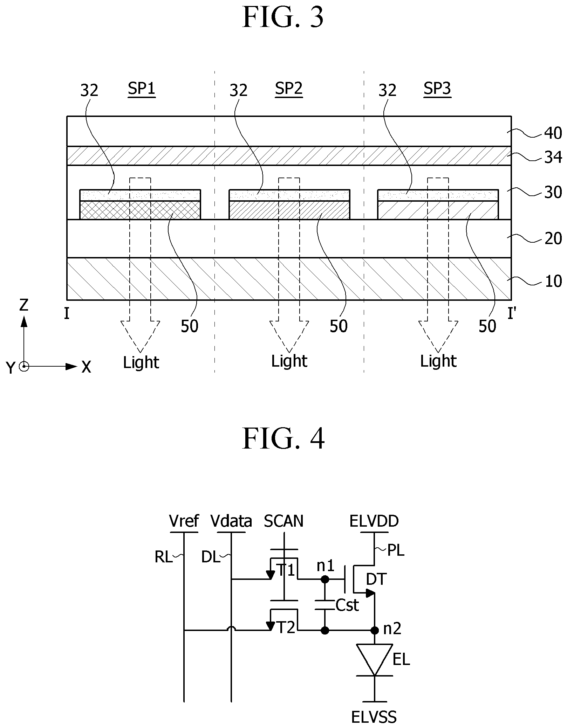

FIG. 1 is a plan view illustrating a pixel of a display panel according to an embodiment of the present disclosure. FIG. 2 is a cross-sectional view schematically illustrating an example of a cross-sectional structure of a pixel taken along the line 'I-I' of FIG. 1 in a top emission type display panel. FIG. 3 is a cross-sectional view schematically showing an example of a cross-sectional structure of a pixel taken along the line 'I-I' of FIG. 1 in a bottom emission type display panel.

Referring to FIGS. 1 to 3, a display panel according to an embodiment of the present disclosure has a length (X), a width (Y), and a thickness (Z). The display panel may be rectangular when viewed in plan view, or may have a variant shape that includes at least a portion that is curved or elliptical.

A substrate 10 of the display panel may be manufactured based on glass, plastic, or silicon wafer. The substrate 10 may be construed as a backplane.

A plurality of pixels PIX is disposed on the display panel. Each of the pixels PIX may include a red (R) sub-pixel SP1, a green (G) sub-pixel SP2, and a blue (B) sub-pixel SP3 for color implementation. Each of the pixels may further include a white (W) sub-pixel. The size or shape of each of the sub-pixels SP1, SP2, and SP3 may be variously modified. A recessed trench T may be disposed between the adjacent sub-pixels SP1, SP2, and SP3. The trench T blocks a current flowing between the adjacent sub-pixels. The trench T may block a leakage current flowing to the sub-pixel by lengthening a current path between the adjacent sub-pixels SP1, SP2, and SP3.

A circuit layer 20, a light-emitting element layer 30, and an encapsulation layer 40 may be stacked on the substrate 10.

The circuit layer 20 includes a pixel circuit that drives light-emitting elements of the sub-pixels SP1, SP2, and SP3 based on pixel data of an input image. The circuit layer 20 may further include a gate driving circuit that supplies a gate signal to the pixel circuit. The pixel circuit may include a driving transistor that supplies a current to the light-emitting element based on its gate-source voltage, a switching transistor that applies a data voltage of the pixel data to the gate or source of the driving transistor, a storage capacitor that maintains the gate-source voltage of the driving transistor, a plurality of insulating layers that insulate metal patterns of such circuit elements, and the like.

The light-emitting element layer 30 includes a light-emitting element disposed in each of the sub-pixels SP1, SP2, and SP3 and driven by the pixel circuit. The light-emitting element may be a white light-emitting element that is commonly disposed in the sub-pixels SP1, SP2, and SP3 to generate white light. In another embodiment, a red light-emitting element that generates red light may be disposed in the red sub-pixel SP1, and a green light-emitting element that generates green light may be disposed in the green sub-pixel SP2. A blue light-emitting element that generates blue light may be disposed in the blue sub-pixel SP3.

When the white light-emitting element is disposed in the sub-pixels SP1, SP2, and SP3, a color filter 50 may be disposed to selectively transmit a wavelength of each color. The light-emitting elements of the light-emitting element layer 30 may be covered by multiple passivation layers including organic and inorganic layers.

The light-emitting element may be implemented as an organic light-emitting element or an inorganic light-emitting element. For example, the light-emitting element may be implemented with an organic light-emitting diode (OLED) or an inorganic LED. The light-emitting element may include a first electrode 32, a second electrode 34, and an emission layer formed between the electrodes 32 and 34. The first electrode 32 may be an anode electrode of the light-emitting element separated for each sub-pixel. The second electrode 34 may be a common electrode shared by the sub-pixels. The second electrode 34 may be a cathode electrode of the light-emitting element.

The encapsulation layer 40 covers the light-emitting element layer 30 to seal the circuit layer 20 and the light-emitting element layer 30. The encapsulation layer 40 may have a multi-insulating layer structure in which an organic layer and an inorganic layer are alternately stacked. The inorganic layer blocks the permeation of moisture or oxygen. The organic layer flattens the surface of the inorganic layer. When the organic layer and the inorganic layer are stacked in multiple layers, a movement path of moisture or oxygen becomes longer compared to a single layer, so that the permeation of moisture and oxygen affecting the light-emitting element layer 30 may be effectively blocked.

The display panel may have a top emission type structure as shown in FIG. 2 or a bottom emission type structure as shown in FIG. 3.

In the top emission type display panel, as shown in FIG. 2, light from the light-emitting element layer 30 is emitted to the outside through the second electrode 34, the encapsulation layer 40, and the color filter 50. In the top emission type display panel, the first electrode 32 may also serve as a reflective layer to increase light efficiency, and the second electrode 34 may be implemented as a transparent or translucent electrode. In the top emission type display panel, a distance between the first electrode 32 and the second electrode 34 may be set to be different for each color of the sub-pixels SP1, SP2, and SP3 to achieve a microcavity effect. When the microcavity is used, light reflected between the electrodes 32 and 34 undergoes constructive interference, which increases the amplitude at the wavelength of the light, thereby increasing the amount of light emitted to the outside in the top emission type.

In the bottom emission type display panel, as shown in FIG. 3, light from the light-emitting element layer 30 is emitted to the outside through the first electrode 32, the color filter 50, the circuit layer 20, and the substrate 10. In the bottom emission type display panel, the second electrode 34 may also serve as a reflective layer to increase light efficiency, and the first electrode 32 may be implemented as a transparent or translucent electrode.

FIG. 4 is a diagram illustrating a circuit of a sub-pixel included in the display panel shown in FIG. 1.

Referring to FIG. 4, a sub-pixel includes a light-emitting element EL, a driving transistor DT for supplying current to the light-emitting element EL, a plurality of switching transistors T1 and T2, and a storage capacitor Cst. The driving transistor DT and the switching transistors T1 and T2 may be implemented as n-channel transistors, but are not necessarily limited thereto and may be implemented as p-channel transistors.

The transistor may be an oxide thin film transistor (TFT) including an oxide semiconductor, or a low temperature poly silicon (LTPS) TFT including a low temperature poly silicon (LTPS).

A transistor is a three-electrode element having a gate, a source, and a drain. The source is an electrode for supplying a carrier to the transistor. Within the transistor, carriers begin to flow from the source. The drain is an electrode through which carriers exit the transistor externally. In a transistor, the flow of carriers flows from the source to the drain. In the case of an n-channel transistor, since the carriers are electrons, a source voltage is lower than a drain voltage, allowing electrons to flow from the source to the drain. In an n-channel transistor, the direction of current flow is from the drain to the source. In the case of a p-channel transistor, since the carriers are holes, the source voltage is higher than the drain voltage, allowing holes to flow from the source to the drain. In a p-channel transistor, since the current flows from the source to the drain because holes flow from the source to the drain. It should be noted that the source and drain of the transistor are not fixed. For example, the source and drain may be changed depending on an applied voltage. Thus, the disclosure is not limited by the source and drain of the transistor. In the following descriptions, the source and drain of the transistor are referred to as first and second electrodes.

A pixel driving voltage, that is, a high potential voltage ELVDD, is applied to a drain electrode of a driving element DT through a high potential voltage line PL. The driving transistor DT supplies current to a light-emitting element EL according to a gate-source voltage Vgs to drive the light-emitting element EL. The light-emitting element EL is turned on and emits light when a forward voltage between the anode electrode and the cathode electrode is greater than a threshold voltage. A low potential voltage ELVSS is applied to the cathode electrode of the light-emitting element EL.

The storage capacitor Cst is connected between a first node n1 and a second node n2 to maintain the gate-source voltage Vgs of the driving transistor DT.

The first switching transistor T1 is turned on according to a gate-on voltage of a scan pulse SCAN applied from a gate line to connect a data line DL to the first node n1.

The second switching transistor T2 applies a reference voltage Vref in response to the scan pulse SCAN applied from the gate line. The reference voltage Vref is applied to the second node n2 through a reference voltage line RL.

The second switching transistor T2 may control sensing a voltage of the second node through the sensing line in response to the scan pulse SCAN applied from the gate line.

The light-emitting element EL may be implemented as organic light-emitting diodes (OLEDs). The OLED includes an organic compound layer formed between an anode electrode and a cathode electrode. The organic compound layer may include, but is not limited to, a hole injection layer (HIL), a hole transport layer (HTL), an emission layer (EML), an electron transport layer (ETL), and an electron injection layer (EIL).

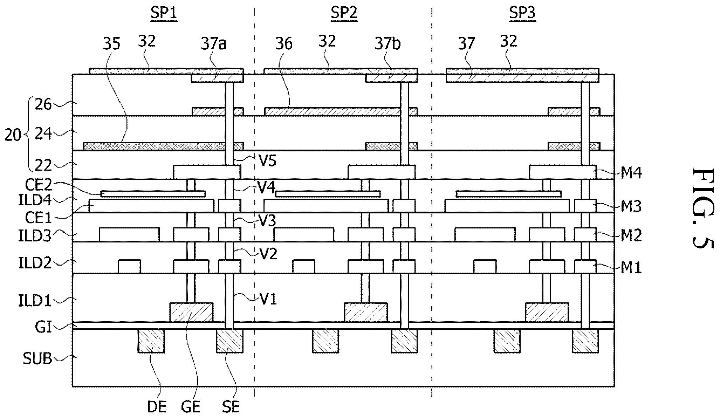

FIG. 5 is a cross-sectional view illustrating a display panel including the sub-pixel shown in FIG. 4. In FIG. 5, a substrate, an encapsulation layer, a color filter, etc., are omitted. The display panel shown in FIG. 5 provides a micro cavity effect in each of the sub-pixels SP1, SP2, and SP3.

Referring to FIG. 5, it shows the driving transistor DT and the storage capacitor Cst included in a red sub-pixel SP1, a green sub-pixel SP2, and a blue sub-pixel SP3.

A driving transistor may be formed on a substrate SUB. The drain electrode DE and the source electrode SE of the driving transistor may be formed on the substrate SUB. The substrate SUB may be a silicon substrate. The drain electrode DE and the source electrode SE may be made of a conductive material such as, but not limited to, copper (Cu), aluminum (Al), molybdenum (Mo), titanium (Ti), or an alloy thereof.

A gate insulating layer GI may be formed on the substrate SUB. The gate insulating layer GI may be formed between the substrate SUB and the gate electrode GE of the driving transistor. The gate electrode GE may be made of a conductive material such as, but not limited to, copper (Cu), aluminum (Al), molybdenum (Mo), titanium (Ti), or an alloy thereof.

The gate electrode GE may be formed on the gate insulating layer GI, and a first intermediate insulating layer ILD1 may be formed covering the gate electrode GE.

A first metal layer M1 may be formed on an upper portion of the first intermediate insulating layer ILD1, and a second intermediate insulating layer ILD2 may be formed covering the first metal layer M1.

A second metal layer M2 may be formed on an upper portion of the second intermediate insulating layer ILD2, and a third intermediate insulating layer ILD3 may be formed covering the second metal layer M2.

A third metal layer M3 may be formed on an upper portion of the third intermediate insulating layer ILD3, and a fourth intermediate insulating layer ILD4 may be formed covering the third metal layer M3.

A fourth metal layer M4 may be formed on an upper portion of a fourth intermediate insulating layer ILD4.

Here, the storage capacitor Cst may include a first electrode CE1 electrically connected to the first node n1 and a second electrode CE2 electrically connected to the second node n2.

In this case, the first intermediate insulating layer ILD1, the second intermediate insulating layer ILD2, the third intermediate insulating layer ILD3, and the fourth intermediate insulating layer ILD4 may be formed of an inorganic insulating material, such as, but is not limited to, silicon nitride (SiNx), silicon dioxide (SiO2), and the like.

In addition, the first metal layer M1, the second metal layer M2, the third metal layer M3, and the fourth metal layer M4, which are disposed in different layers, may be electrically connected through vias V1, V2, V3, V4, and V5. For example, the via may be formed of a material such as, but is not limited to, tungsten (W) or the like.

An upper portion of the fourth intermediate insulating layer ILD4 may be formed with a first insulating layer 22 covering the fourth metal layer M4.

A first reflective layer 35 may be formed on an upper portion of the first insulating layer 22 of the first sub-pixel, e.g., the red sub-pixel SP1, and a second insulating layer 24 may be formed covering the first reflective layer 35.

A second reflective layer 36 may be formed on an upper portion of the second insulating layer 24 of the second sub-pixel, e.g., the green sub-pixel SP2, and a third insulating layer 26 may be formed covering the second reflective layer 36.

A third reflective layer 37 may be formed on an upper portion of the third insulating layer 26 of the third sub-pixel, e.g., the blue sub-pixel SP3.

A first electrode 32 may be formed on the upper portion of the third insulating layer 26. The first electrode 32 may be formed of a thin metal material such as aluminum (Al), so as to transmit light.

In this case, the first insulating layer 22, the second insulating layer 24, and the third insulating layer 26 may be formed of an inorganic insulating material such as silicon nitride (SiNx) or silicon dioxide (SiO2). In addition, the first reflective layer 35, the second reflective layer 36, and the third reflective layer 37 disposed in different layers may be formed of a highly reflective material, such as, but is not limited to, titanium (Ti), aluminum (Al), and titanium nitride (TiN).

In order to increase the amount of light of each color in each of the sub-pixels SP1, SP2, and SP3 by using the microcavity effect, the thickness of the insulating layer between the first electrode 32 and the reflective layers 35, 36, and 37 may be different for each sub-pixel. For example, the insulating layers 24 and 26 between the first electrode 32 and the reflective layer 35 of the red sub-pixel SP1 are thicker than the insulating layer 26 between the first electrode 32 and the reflective layer 36 of the green sub-pixel SP2. In the blue sub-pixel SP3, the first electrode 32 and the reflective layer 37 may be in contact without a gap. The reflective layers 35, 36, and 37 of each of the sub-pixels SP1, SP2, and SP3 may be formed of the same or different stacked structures and/or materials.

This allows embodiments to improve efficiency by using the microcavity effect, which amplifies peaks at certain wavelengths for each R, G, and B pixel while suppressing light transmission at other wavelengths.

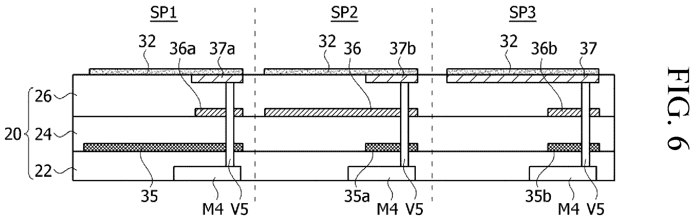

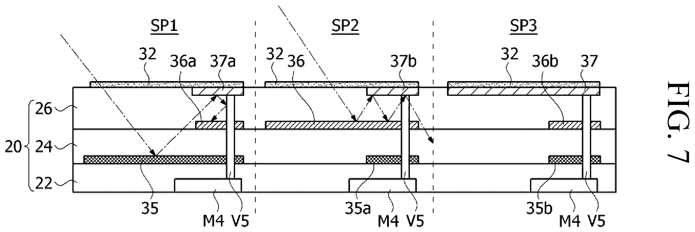

FIG. 6 is a diagram illustrating a structure of a circuit layer according to a first embodiment of the present disclosure, and FIG. 7 is a diagram for explaining a structure and function of a residual reflective layer shown in FIG. 6.

Referring to FIG. 6, a circuit layer 20 according to the first embodiment may include a first insulating layer 22 covering the fourth metal layer M4, the second insulating layer 24 disposed on the upper portion of the first insulating layer 22, and a third insulating layer 26 disposed on the upper portion of the second insulating layer 24.

A first reflective layer 35, a second reflective layer 36, and a third reflective layer 37 may be formed in different layers of each sub-pixel. In addition to the reflective layer, a residual reflective layer may be formed in each sub-pixel. The residual reflective layer may be formed on an insulating layer different from the layer on which the reflective layer is formed.

The source electrode SE, the first metal layer M1, the second metal layer M2, the third metal layer M3, and the fourth metal layer M4 of the driving transistor of FIG. 5 are electrically connected through different vias V1, V2, V3, and V4, respectively, but the fourth metal layer M4 and a third-a residual reflective layer 37a, the fourth metal layer M4 and a third-b residual reflective layer 37b, and the fourth metal layer M4 and the third reflective layer 37 may each be electrically connected through one via V5.

Instead of the fourth metal layer M4 and the third-a residual reflective layer 37a, the fourth metal layer M4 and the third-b residual reflective layer 37b, and the fourth metal layer M4 and the third reflective layer 37 are electrically connected to each other through a plurality of vias, when electrically connecting from the fourth metal layer M4 to the third-a residual reflective layer 37a, from the fourth metal layer M4 to the third-b residual reflective layer 37b, and from the fourth metal layer M4 to the third reflective layer 37 through one via at a time, the process of forming the vias may be reduced from three times to one time. This process simplification may not only reduce process tact time, thereby shortening the development schedule, but also reduce manufacturing costs by reducing the number of via masks.

The first reflective layer 35 may be formed on an upper portion of the first insulating layer 22 of the red sub-pixel SP1. The first reflective layer 35 may be formed to have the same size or area as the first electrode 32. A first-a residual reflective layer 35a may be formed on an upper portion of the first insulating layer 22 of the green sub-pixel SP2. A first-b residual reflective layer 35b may be formed on an upper portion of the first insulating layer 22 of the blue sub-pixel SP3. In this case, the first-a residual reflective layer 35a and the first-b residual reflective layer 35b may be formed to be smaller than the size or area of the first reflective layer 35.

The second reflective layer 36 may be formed on an upper portion of the second insulating layer 24 of the green sub-pixel SP2. The second reflective layer 36 may be formed to have the same size or area as the first electrode 32. A second-a residual reflective layer 36a may be formed on an upper portion of the second insulating layer 24 of the red sub-pixel SP1. A second-b residual reflective layer 36b may be formed on an upper portion of the second insulating layer 24 of the blue sub-pixel SP3. In this case, the second-a residual reflective layer 36a and the second-b residual reflective layer 36b may be formed to be smaller than the size or area of the second reflective layer 36.

The third reflective layer 37 may be formed on an upper portion of the third insulating layer 26 of the blue sub-pixel SP3. The third reflective layer 37 may be formed to have the same size or area as the first electrode 32. The third-a residual reflective layer 37a may be formed on an upper portion of the third insulating layer 26 of the red sub-pixel SP1. A third-b residual reflective layer 37b may be formed on an upper portion of the third insulating layer 26 of the green sub-pixel SP2. In this case, the third-a residual reflective layer 37a and the third-b residual reflective layer 37b may be formed to be smaller than the size or area of the third reflective layer 37.

In this case, the residual reflective layer is formed to a predetermined size, but may be varied depending on a wavelength band of the reflected light. For example, when light in a relatively short wavelength band is reflected, the size of the residual reflective layer is formed small, and when light in a relatively long wavelength band is reflected, the size of the residual reflective layer is formed large. However, it is not necessarily limited to this.

For example, if there is light incident at a predetermined angle rather than light incident vertically on the first reflective layer 35 of the red sub-pixel SP1, as shown in FIG. 7, light may be trapped within the circuit layer and canceled out by the second-a residual reflective layer 36a and the third-a residual reflective layer 37a.

In this way, the color purity of the red sub-pixel SP1 may be increased by cancelling out the light incident at an unwanted angle therein in addition to the light incident at the desired angle.

As another example, when there is light obliquely incident at a predetermined angle rather than light vertically incident on the second reflective layer 36 of the green sub-pixel SP2, as shown in FIG. 7, the light path may be changed in a different direction by the second-b residual reflective layer 36b and the third-b residual reflective layer 37b.

In this way, the color purity of the green sub-pixel SP2 may be increased by changing the light incident at an unwanted angle to a path in a different direction in addition to the light incident at the desired angle.

In addition, the residual reflective layers may also serve to support vias in each sub-pixel.

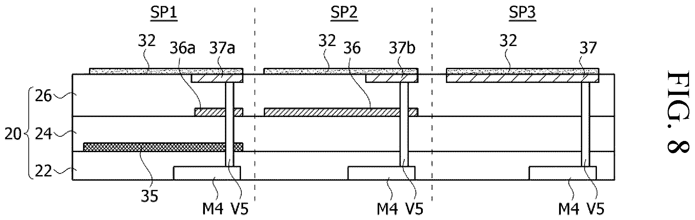

FIG. 8 is a diagram illustrating a modified embodiment of the circuit layer shown in FIG. 6;

Referring to FIG. 8, a circuit layer 20 according to the modified embodiment may include a first insulating layer 22 covering the fourth metal layer M4, a second insulating layer 24 disposed on the upper portion of the first insulating layer 22, and a third insulating layer 26 disposed on the upper portion of the second insulating layer 24.

The first reflective layer 35, the second reflective layer 36, and the third reflective layer 37 may be formed in different layers of each sub-pixel, and only at least a portion of the residual reflective layers of FIG. 6 may be formed.

All residual reflective layers do not cancel out light incident at an unwanted angle as shown in FIG. 7, or redirect it to another light path. That is, in FIG. 7, the second-a residual reflective layer 36a and the third-a residual reflective layer 37a are used in the red sub-pixel, and the third-b residual reflective layer 37b is used in the green sub-pixel, but other residual reflective layers are not used.

Therefore, in the modified embodiment, it is intended to select and form only the residual reflective layer necessary to cancel out light incident at an unwanted angle or redirect it to another light path.

That is, in the modified embodiment, only the residual reflective layers located on the upper portion of each of the first reflective layer 35, the second reflective layer 36, and the third reflective layer 37 in each sub-pixel, that is, the second-a residual reflective layer 36a, the third-a residual reflective layer 37a and the third-b residual reflective layer 37b, may be selectively formed.

This modified embodiment is only one example, and various modifications are possible without being limited thereto.

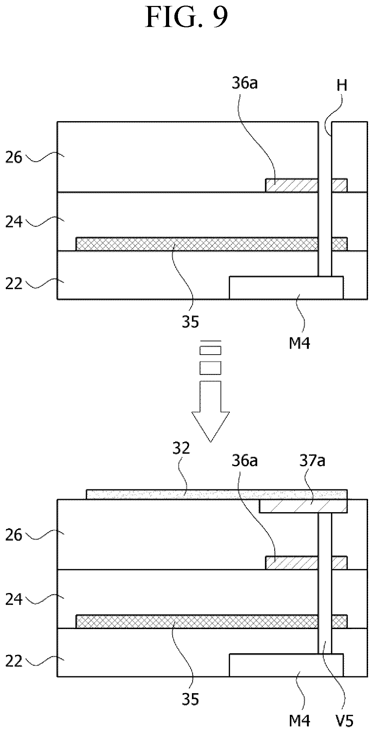

FIG. 9 is a diagram for explaining a principle of connection between reflective layers illustrated in FIG. 6;

Referring to FIG. 9, in the case of a red sub-pixel, the first reflective layer 35, the second insulating layer 24, the second-a residual reflective layer 36a and the third insulating layer 26 are sequentially stacked on the first insulating layer 22 covering the fourth metal layer M4.

After a hole (or via hole) H penetrating the first insulating layer 22, the first reflective layer 35, the second insulating layer 24, the second-a residual reflective layer 36a, and the third insulating layer 26 is formed, and then a via V5 is formed in the hole H, the third-a residual reflective layer 37a and the first electrode 32 are sequentially stacked.

In this case, the hole H may be formed to have, but is not necessarily limited to, a fixed diameter, and may be formed in various shapes. For example, the upper portion of the hole H may be wider than the lower portion.

From the fourth metal layer M4 to the third-a residual reflective layer 37a, they are electrically connected to through one via V5. Since the first electrode 32 is formed on the upper portion of the third-a residual reflective layer 37a, there may be an electrical connection from the fourth metal layer M4 to the first electrode 32.

In addition, the green sub-pixel and the blue sub-pixel may be formed by the same process.

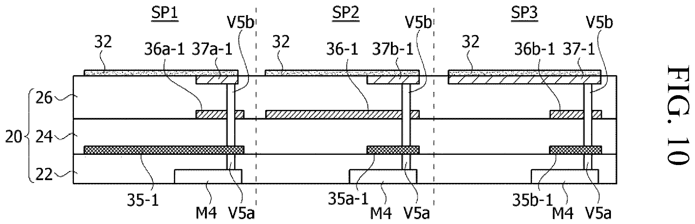

FIG. 10 is a diagram illustrating a structure of a circuit layer according to a second embodiment of the present disclosure.

Referring to FIG. 10, a circuit layer 20 according to the second embodiment may include a first insulating layer 22 covering the fourth metal layer M4, a second insulating layer 24 disposed on the upper portion of the first insulating layer 22, and a third insulating layer 26 disposed on the upper portion of the second insulating layer 24.

A first reflective layer 35-1, a second reflective layer 36-1, and a third reflective layer 37-1 may be formed in different layers of each sub-pixel.

In contrast to the first embodiment, in the second embodiment, the fourth metal layer M4 and the first reflective layer 35-1, the fourth metal layer M4 and a first-a residual reflective layer 35a-1, and the fourth metal layer M4 and the first-b residual reflective layer 35b-1 may each be electrically connected through one via V5a, and the first reflective layer 35-1 and a third-a residual reflective layer 37a-1, the first-a residual reflective layer 35a-1 and the third-b residual reflective layer 37b-1, and the first-b residual reflective layer 35b-1 and the third reflective layer 37-1 may each be electrically connected through another V5b.

Instead of the fourth metal layer M4 and the third-a residual reflective layer 37a-1, the fourth metal layer M4 and the third-b residual reflective layer 37b-1, and the fourth metal layer M4 and the third reflective layer 37 are electrically connected to each other through a plurality of vias, when electrically connecting from the fourth metal layer M4 to the first reflective layer 35-1, from the fourth metal layer M4 to the first-a residual reflective layer 35a-1, and from the fourth metal layer M4 to the first-b residual reflective layer 35b-1 through one via V5a at a time; and when electrically connecting from the first reflective layer 35-1 to the third-a residual reflective layer 37a-1, from the first-a residual reflective layer 35a-1 to the third-b residual reflective layer 37b-1, and from the first-b residual reflective layer 35b-1 to the third reflective layer 37-1 through another via V5b at one time, the process of forming the vias may be reduced from three times to two times. Because one process is reduced, this process simplification may not only reduce process tact time, thereby shortening the development schedule, but also reduce manufacturing costs by reducing the number of via masks.

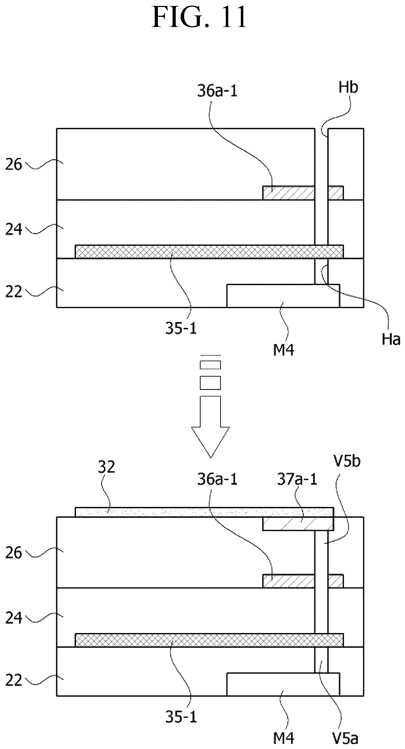

FIG. 11 is a diagram for explaining a principle of connection between reflective layers illustrated in FIG. 10.

Referring to FIG. 11, in the case of a red sub-pixel, after a hole (or via hole) Ha penetrating the first insulating layer 22 covering the fourth metal layer M4, and then a via V5a is formed in the hole Ha, the first reflective layer 35-1, the second insulating layer 24, the second-a residual reflective layer 36a-1, and the third insulating layer 26 are sequentially stacked.

After a hole (or via hole) Hb penetrating the second insulating layer 24, the second-a residual reflective layer 36a-1, and the third insulating layer 26 is formed, and then a via V5b is formed in the hole Hb, the third-a residual reflective layer 37a-1 and the first electrode 32 are sequentially stacked.

The fourth metal layer M4 and the first reflective layer 35-1 are connected through one via V5a, and from the first reflective layer 35-1 to the third-a residual reflective layer 37a-1, they are electrically connected to through another via V5b. Since the first electrode 32 is formed on the upper portion of the third-a residual reflective layer 37a-1, there may be an electrical connection from the fourth metal layer M4 to the first electrode 32.

In addition, the green sub-pixel and the blue sub-pixel may be formed by the same process.

The hole may not be formed with a diameter of a fixed size, and may be formed to have a large upper portion. The reason why the two vias are formed as in the second embodiment is that when the fourth metal layer M4 and the third reflective layer 37-1 are is electrically connected to each other through one via as shown in FIG. 8 of the first embodiment, a portion where the via is formed is relatively deeper, thereby increasing the upper diameter of the hole where the via is formed, and a decrease in opening may occur due to the upper diameter of the hole.

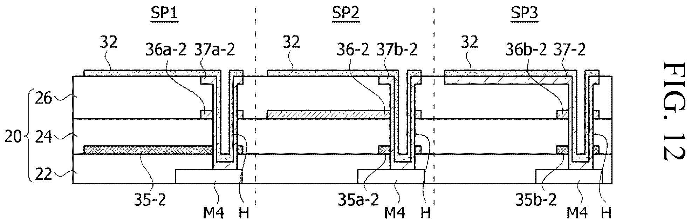

FIG. 12 is a diagram illustrating a structure of a circuit layer according to a third embodiment of the present disclosure.

Referring to FIG. 12, a circuit layer 20 according to the third embodiment may include a first insulating layer 22 covering the fourth metal layer M4, a second insulating layer 24 disposed on the upper portion of the first insulating layer 22, and a third insulating layer 26 disposed on the upper portion of the second insulating layer 24.

A first reflective layer 35-2, a second reflective layer 36-2, and a third reflective layer 37-2 may be formed in different layers of each sub-pixel. Here, the third reflective layer 37-2 may be configured to serve as a via.

The hole (or contact hole) H may be formed by penetrating the first insulating layer 22 covering the fourth metal layer M4, the second insulating layer 24, and the third insulating layer 26. The hole H may be formed to expose the upper surface of the fourth metal layer M4.

A third-a residual reflective layer 37a-2, a third-b residual reflective layer 37b-2, and a third reflective layer 37-2 may be formed on an upper portion of the third insulating layer 26 where the hole H is formed. The third-a residual reflective layer 37a-2, the third-b residual reflective layer 37b-2, and the third reflective layer 37-2 are each formed along the hole H so that the upper surface formed on the upper portion of the third insulating layer 26 is in contact with the first electrode 32, and the lower surface of the portion formed along the hole is in contact with the fourth metal layer M4, whereby the first electrode 32 and the fourth metal layer M4 may be electrically connected. The residual reflective layer (37a-2 and 37b-2) of the red and green sub-pixels SP1 and SP2 and the third reflective layer 37-2 of the blue sub-pixel SP3 may have an upper surface of a portion formed in the third insulating layer 26 in contact with the first electrode 32, and a lower surface of a portion formed along each hole H in contact with each metal layer M4.

The third-a residual reflective layer 37a-2 of the red sub-pixel SP1 may be formed on the upper portion of the third insulating layer 26 along the hole H. The third-a residual reflective layer 37a-2 may be formed along a side surface and a bottom surface of the hole so as to be electrically connected to the fourth metal layer M4 through the bottom surface of the hole H, and so as to be electrically connected to the first reflective layer 35-2 and the second-a residual reflective layer 36a-2 through the side surface of the hole H.

The third-b residual reflective layer 37b-2 of the green sub-pixel SP2 may be formed on the upper portion of the third insulating layer 26 along the hole H. The third-b residual reflective layer 37b-2 may be formed along the side surface and the bottom surface of the hole so as to be electrically connected to the fourth metal layer M4 through the bottom surface of the hole H, and so as to be electrically connected to the first-a residual reflective layer 35a-2 and the second reflective layer 36-2 through the side surface of the hole H.

The third reflective layer 37-2 of the blue sub-pixel SP3 is formed on the upper portion of the third insulating layer 26 along the hole H. The third reflective layer 37-2 may be formed along the side surface and the bottom surface of the hole so as to be electrically connected to the fourth metal layer M4 through the bottom surface of the hole H, and so as to be electrically connected to the first-b residual reflective layer 35b-2 and the second-b residual reflective layer 36b-2 through the side surface of the hole H.

The first electrode 32 may be formed on the upper portion of the third insulating layers 26 on which the third-a residual reflective layer 37a-2, the third-b residual reflective layer 37b-2, and the third reflective layer 37-2 are each formed.

In contrast to the first and second embodiments, in the third embodiment, the fourth metal layer M4 and the first electrode 32 may be electrically connected to each other through the third-a residual reflective layer 37a-2, the third-b residual reflective layer 37b-2, and the third reflective layer 37-2 formed along the hole H without forming a via.

Instead of the fourth metal layer M4 and the third-a residual reflective layer 37a-2, the fourth metal layer M4 and the third-b residual reflective layer 37b-2, and the fourth metal layer M4 and the third reflective layer 37-2 are electrically connected to each other through a plurality of vias, when the fourth metal layer M4 and the third-a residual reflective layer 37a-2, the fourth metal layer M4 and the third-b residual reflective layer 37b-2, and the fourth metal layer M4 and the third reflective layer 37-2 are electrically connected to each other at one time through a hole H, the process of forming the hole may be reduced from three times to one time. Because two processes are reduced, this process simplification may not only reduce process tact time, thereby shortening the development schedule, but also reduce manufacturing costs by reducing the number of via masks.

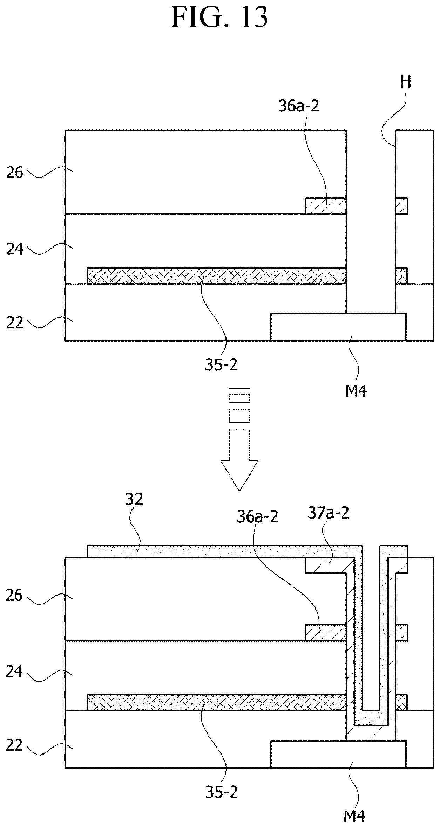

FIG. 13 is a diagram for explaining a principle of connection between reflective layers illustrated in FIG. 12.

Referring to FIG. 13, in the case of a red sub-pixel, the first reflective layer 35-2, the second insulating layer 24, the second-a residual reflective layer 36a-2, and the third insulating layer 26 are sequentially stacked on the first insulating layer 22 covering the fourth metal layer M4.

After a hole (or via hole) H penetrating the first insulating layer 22, the first reflective layer 35-2, the second insulating layer 24, the second-a residual reflective layer 36a-2, and the third insulating layer 26 is formed, and then the third-a residual reflective layer 37a-2 is formed along the hole H, the first electrode 32 is formed on the upper portion of the third-a residual reflective layer 37a-2.

In this case, the hole H may be formed to have, but is not necessarily limited to, a fixed diameter, and may be formed in various shapes. For example, the upper portion of the hole H may be wider than the lower portion.

The fourth metal layer M4 and the third-a residual reflective layer 37a-2 are electrically connected to each other through one hole H, that is, through the third-a residual reflective layer 37a-2 formed along one hole H. Since the first electrode 32 is formed on the upper portion of the third-a residual reflective layer 37a-2, the fourth metal layer M4 and the first electrode 32 may be electrically connected to each other.

In addition, the green sub-pixel and the blue sub-pixel may be formed by the same process.

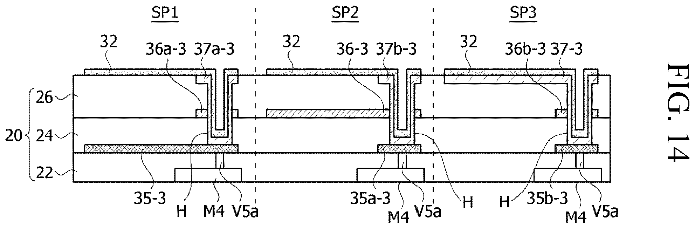

FIG. 14 is a diagram illustrating a structure of a circuit layer according to a fourth embodiment of the present disclosure.

Referring to FIG. 14, a circuit layer 20 according to the fourth embodiment may include a first insulating layer 22 covering the fourth metal layer M4, a second insulating layer 24 disposed on the upper portion of the first insulating layer 22, and a third insulating layer 26 disposed on the upper portion of the second insulating layer 24.

A first reflective layer 35-3, a second reflective layer 36-3, and a third reflective layer 37-3 may be formed in different layers of each sub-pixel. Here, the third reflective layer 37-3 may be configured to serve as a via.

The fourth metal layer M4 and the first reflective layer 35-3, the fourth metal layer M4 and the first-a residual reflective layer 35a-3, and the fourth metal layer M4 and the first-b residual reflective layer 35b-3 may be electrically connected to each other through a via V5a, and the first reflective layer 35-3 and the first electrode 32, the first-a residual reflective layer 35a-3 and the first electrode 32, and the first-b residual reflective layer 35b-3 and the first electrode 32 may be electrically connected to each other through the third-a residual reflective layer 37a-3, the third-b residual reflective layer 37b-3, and the third reflective layer 37-3 formed along the hole H.

The hole H may be formed by penetrating the second insulating layer 24 and the third insulating layer 26. The hole H may be formed to expose the upper surfaces of the first reflective layer 35-3, the first-a residual reflective layer 35a-3, and the first-b residual reflective layer 35b-3.

The third-a residual reflective layer 37a-3, the third-b residual reflective layer 37b-3, and the third reflective layer 37-3 may be formed on the upper portion of the third insulating layer 26 where the hole H is formed. The third-a residual reflective layer 37a-3, the third-b residual reflective layer 37b-3, and the third reflective layer 37-3 are each formed along the hole H so that the upper surface formed on the upper portion of the third insulating layer 26 is in contact with the first electrode 32, and the lower surface of the portion formed along the hole is in contact with the first reflective layer 35-3, the first-a residual reflective layer 35a-3, and the first-b residual reflective layer 35b-3, whereby the first electrode 32 and the fourth metal layer M4 may be electrically connected to each other.

The third-a residual reflective layer 37a-3 of the red sub-pixel SP1 may be formed on the upper portion of the third insulating layer 26 along the hole H. The third-a residual reflective layer 37a-3 may be formed along a side surface and a bottom surface of the hole so as to be electrically connected to the first reflective layer 35-3 through the bottom surface of the hole H, and so as to be electrically connected to the second-a residual reflective layer 36a-3 through the side surface of the hole H.

The third-b residual reflective layer 37b-3 of the green sub-pixel SP2 may be formed on the upper portion of the third insulating layer 26 along the hole H. The third-b residual reflective layer 37b-3 may be formed along the side surface and the bottom surface of the hole so as to be electrically connected to the first-a residual reflective layer 35a-3 through the bottom surface of the hole H, and so as to be electrically connected to the second reflective layer 36-3 through the side surface of the hole H.

The third reflective layer 37-3 of the blue sub-pixel SP3 is formed on the upper portion of the third insulating layer 26 along the hole H. The third reflective layer 37-3 may be formed along the side surface and the bottom surface of the hole so as to be electrically connected to the first-b residual reflective layer 35b-3 through the bottom surface of the hole H, and so as to be electrically connected to the second-b residual reflective layer 36b-3 through the side surface of the hole H.

The first electrode 32 may be formed on the upper portion of the third insulating layers 26 on which the third-a residual reflective layer 37a-3, the third-b residual reflective layer 37b-3, and the third reflective layer 37-3 are each formed.

In contrast to the third embodiment, in the fourth embodiment, the fourth metal layer M4 and the first reflective layer 35-3, the fourth metal layer M4 and the first-a residual reflective layer 35a-3, and the fourth metal layer M4 and the first-b residual reflective layer 35b-3 may be electrically connected to each other through one via V5a, and the first reflective layer 35-3 and the first electrode 32, the first-a residual reflective layer 35a-3 and the first electrode 32, and the first-b residual reflective layer 35b-3 and the first electrode 32 may be electrically connected to each other through the third-a residual reflective layer 37a-3, the third-b residual reflective layer 37b-3, and the third reflective layer 37-3 formed along the hole H.

Instead of the fourth metal layer M4 and the third-a residual reflective layer 37a-3, the fourth metal layer M4 and the third-b residual reflective layer 37b-3, and the fourth metal layer M4 and the third reflective layer 37-3 are electrically connected to each other through a plurality of vias, when the fourth metal layer M4 and the first reflective layer 35-3, the fourth metal layer M4 and the first-a residual reflective layer 35a-3, and the fourth metal layer M4 and the first-b residual reflective layer 35b-3 are electrically connected to each other through a via V5a, and the first reflective layer 35-3 and the first electrode 32, the first-a residual reflective layer 35a-3 and the first electrode 32, and the first-b residual reflective layer 35b-3 and the first electrode 32 are electrically connected to each other at one time through each of the third-a residual reflective layer 37a-3, the third-b residual reflective layer 37b-3 and the third reflective layer 37-3 formed along the hole H, the process of forming the vias may be reduced from three times to two times. This process simplification may not only reduce process tact time, thereby shortening the development schedule, but also reduce manufacturing costs by reducing the number of via masks.

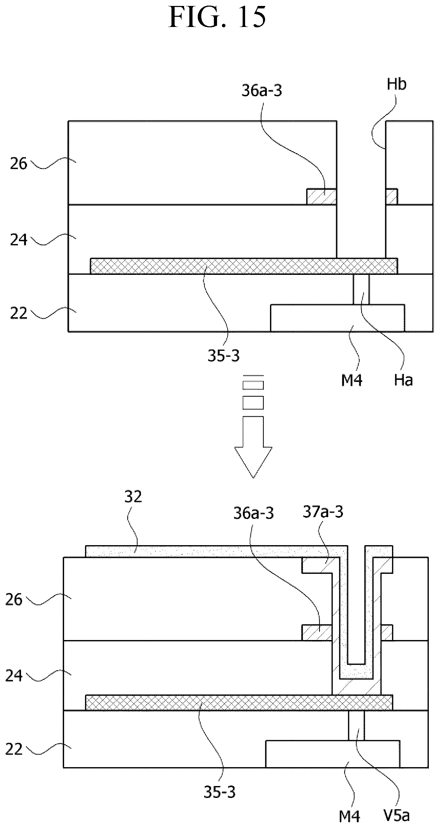

FIG. 15 is a diagram for explaining a principle of connection between reflective layers illustrated in FIG. 14.

Referring to FIG. 15, in the case of a red sub-pixel, after a hole (or via hole) Ha penetrating the first insulating layer 22 covering the fourth metal layer M4, and then a via V5a is formed in the hole Ha, the first reflective layer 35-3, the second insulating layer 24, the second-a residual reflective layer 36a-3, and the third insulating layer 26 are sequentially stacked.

After a hole (or via hole) Hb penetrating the second insulating layer 24, the second-a residual reflective layer 36a-3, and the third insulating layer 26 is formed, and then the third-a residual reflective layer 37a-3 is formed along the hole Hb, the first electrode 32 is formed on the upper portion of the third-a residual reflective layer 37a-3.

The fourth metal layer M4 and the first reflective layer 35-3 are connected to each other through one via V5a, and the first reflective layer 35-3 is electrically connected to the third-a residual reflective layer 37a-3 through one hole Hb, that is, through the third-a residual reflective layer 37a-3 formed along one hole Hb. Since the first electrode 32 is formed on the upper portion of the third-a residual reflective layer 37a-3, the fourth metal layer M4 and the first electrode 32 may be electrically connected to each other.

In addition, the green sub-pixel and the blue sub-pixel may be formed by the same process.

The display panel of the above-described embodiments may implement a left-eye screen and a right-eye screen of a personal immersive device.

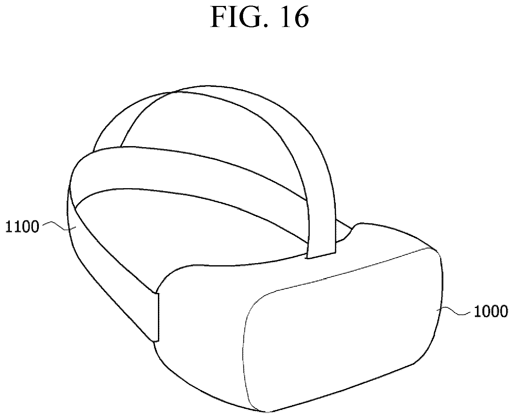

FIG. 16 is a diagram illustrating an example of the appearance of a personal immersive device. The appearance of a personal immersive device is not limited to FIG. 12.

Referring to FIG. 16, the personal immersive device may be manufactured in an HMD type exterior design including a main body 1000 and a head-mounted band 1100.

The main body 1000 may include the display panel of the above-described embodiment, a lens disposed to face a screen of the display panel, a display panel driver, a system controller, a plurality of sensors, and the like. The main body 1000 may further include a camera. The lens may include an eyepiece or a fisheye lens. The display panel driver receives the pixel data of the input image and drives the pixels to display the input image on the pixels of the display panel.

The system controller may include an external device interface connected to a sensor, a camera, or the like and connected to a memory or an external video source, a user interface for receiving a user command, and one or more processors connected to a power supply that generates power. The sensors include various sensors such as a gyro sensor and an acceleration sensor. The sensors transmit their outputs to the system controller. The system controller may receive the outputs of the sensors, move the pixel data of an image displayed on the pixels of the display panel in synchronization with the user's movement, and execute a Foveated Rendering algorithm that follows the user's gaze.

The personal immersive device may be implemented using a mobile terminal system such as a smartphone. In this case, a left-eye image and a right-eye image may be displayed together on the display panel of the mobile terminal system. The smartphone supports VR mode, which is an example of a partial mode. In the VR mode of the smartphone, the left-eye image and the right-eye image may be displayed together in a separate manner on a single display panel. In this case, the configuration of the main body 1000 in FIG. 15 is simplified, and the mobile terminal system supporting the VR mode may be detachably mounted on the main body 1000.

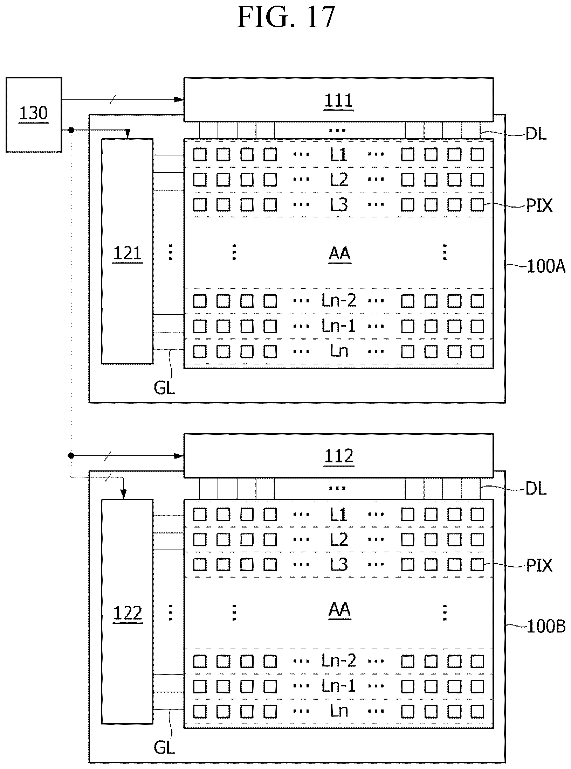

FIG. 17 is a block diagram illustrating an example of a display device applicable to a personal immersive device.

Referring to FIG. 17, the display device may include a first display panel 100A on which a left-eye image is displayed, and a second display panel 100B on which a right-eye image is displayed.

The display panels 100A and 100B include data lines DL, gate lines GL, and the pixels PIX. A screen of the display panels 100A and 100B includes a pixel array on which an image is displayed. The pixel array includes pixel lines L1 to Ln into which pixel data is written by being sequentially scanned by scan pulses shifted along a scanning direction.

The display panel driver may include data drivers 111 and 112, gate drivers 121 and 122, a controller 130, and the like. The data drivers 111 and 112 and the gate drivers 121 and 122 may be separated for each of the display panels 100A and 100B, while the controller 130 may be shared.

The data drivers 111 and 112 convert the pixel data inputted from the controller 130 into voltage or current to supply data signals to the pixels.

The gate drivers 121 and 122 sequentially output scan pulses synchronized with the data signals outputted from the data drivers 111 and 112 under the control of the controller 130.

Various embodiments provide a display panel comprising: a plurality of metal layers on each of (e.g., on respective ones of) a first sub-pixel, a second sub-pixel, and a third sub-pixel; a first insulating layer covering the plurality of metal layers; a first reflective layer on an upper portion of the first insulating layer of the first sub-pixel; a second insulating layer covering the first reflective layer; a second reflective layer on the second insulating layer of the second sub-pixel; a third insulating layer covering the second reflective layer; a third reflective layer on the third insulating layer of the third sub-pixel; a plurality of first electrodes on the third insulating layer of each of the first to third sub-pixels; and a plurality of holes penetrating the first to third insulating layers of each of the first to third sub-pixels, wherein the metal layer of each of the first to third sub-pixels is electrically connected to the respective first electrode of each of the first to third sub-pixels through a respective hole of the plurality of holes.

In one or more embodiments, the display panel further comprises: a first residual reflective layer on an upper portion of each of the first insulating layers of the second and third sub-pixels; a second residual reflective layer on an upper portion of each of the second insulating layers of the first and third sub-pixels; and a third residual reflective layer on an upper portion of each of the third insulating layers of the first and second sub-pixels.

In one or more embodiments, the first to third residual reflective layers have sizes smaller than the sizes of the first to third reflective layers.

In one or more embodiments, the first to third residual reflective layers have different sizes depending on a wavelength band of light.

In one or more embodiments, the display panel further comprises a via in each of the plurality of holes, wherein the respective metal layer is electrically connected to the respective first electrode through the respective via.

In one or more embodiments, each of the third residual reflective layer on an upper portion of the third insulating layer of each of the first and second sub-pixels and the third reflective layer on an upper portion of the third insulating layer of the third sub-pixel has an upper surface in contact with the respective first electrode, and a lower surface electrically connected to the respective metal layer through a respective via in the respective hole of the plurality of holes.

In one or more embodiments, each of the plurality of holes includes a first hole and a second hole, wherein the first hole penetrates the first insulating layer, and wherein the second hole penetrates the second insulating layer and the third insulating layer.

In one or more embodiments, the first reflective layer of the first sub-pixel and the first residual reflective layer of the second and third sub-pixels are electrically connected to the respective metal layer through a respective via in the first hole of the respective hole and electrically connected to the respective first electrode through a respective via in the second hole of the respective hole.

In one or more embodiments, the third residual reflective layers of the first and second sub-pixels and the third reflective layer of the third sub-pixel extend along the respective hole of the plurality of holes to be electrically connected to the respective metal layer of the plurality of metal layers.

In one or more embodiments, the third residual reflective layer of the first and second sub-pixels and the third reflective layer of the third sub-pixel have an upper surface of a portion in the third insulating layer in contact with the respective first electrode, and a lower surface of a portion along the respective hole in contact with the respective metal layer.

In one or more embodiments, each of the plurality of holes includes a first hole and a second hole, the first hole penetrates the first insulating layer, and the second hole penetrates the second insulating layer and the third insulating layer.

In one or more embodiments, the first reflective layer of the first sub-pixel and the first residual reflective layer of the second and third sub-pixels are electrically connected to the respective metal layer through a respective via in the first hole of the respective hole, and are electrically connected to the respective first electrode through a third residual reflective layer of the first and second sub-pixels and a third reflective layer of the third sub-pixel along the second hole of the respective hole.

In one or more embodiments, the display panel further comprises: a second residual reflective layer on an upper portion of the second insulating layer of the first sub-pixel; and a third residual reflective layer on an upper portion of each of the third insulating layers of the first and second sub-pixels.

In one or more embodiments, the display panel further comprises a residual reflective layer formed in each sub-pixel, wherein in each sub-pixel, the residual reflective layer is formed on the insulating layer different from a layer on which a corresponding reflective layer is formed.

Various embodiments provide a display panel comprising: a metal layer; a first insulating layer covering the metal layer; a first reflective layer on an upper portion of the first insulating layer; a second insulating layer covering the first reflective layer; a second reflective layer on an upper portion of the second insulating layer; a third insulating layer covering the second reflective layer; a third reflective layer on an upper portion of the third insulating layer; a first electrode on an upper portion of the third insulating layer; and a hole penetrating the first to third insulating layers, wherein the metal layer is electrically connected to the first electrode through the hole.

In one or more embodiments, one of the first reflective layer, the second reflective layer, and the third reflective layer has a same size as the first electrode according to a color of a sub-pixel, wherein the remaining two reflective layers have a smaller size than the first electrode.

In one or more embodiments, the metal layer is formed on each of a first, second and third sub-pixels (e.g., a respective metal layer may be formed on each of the first to third sub-pixels), wherein the display panel further comprises a residual reflective layer formed in each sub-pixel, and wherein in each sub-pixel, the residual reflective layer is formed on the insulating layer different from a layer on which a corresponding reflective layer is formed.

Although the embodiments of the present disclosure have been described in more detail with reference to the accompanying drawings, the present disclosure is not limited thereto and may be embodied in many different forms without departing from the technical concept of the present disclosure. Therefore, the embodiments disclosed in the present disclosure are provided for illustrative purposes only and are not intended to limit the technical concept of the present disclosure. The scope of the technical concept of the present disclosure is not limited thereto. Therefore, it should be understood that the above-described embodiments are illustrative in all aspects and do not limit the present disclosure.

The various embodiments described above can be combined to provide further embodiments.

These and other changes can be made to the embodiments in light of the above-detailed description. In general, in the following claims, the terms used should not be construed to limit the claims to the specific embodiments disclosed in the specification and the claims, but should be construed to include all possible embodiments. Accordingly, the claims are not limited by the disclosure.

## Claims

1. A display panel comprising:
a plurality of metal layers (M4) on each of a first sub-pixel (SP1), a second sub-pixel (SP2), and a third sub-pixel (SP3);
a first insulating layer (22) covering the plurality of metal layers (M4);
a first reflective layer (35) on an upper portion of the first insulating layer (22) of the first sub-pixel (SP1);
a second insulating layer (24) covering the first reflective layer (35);
a second reflective layer (36) on the second insulating layer (24) of the second sub-pixel (SP2);
a third insulating layer (26) covering the second reflective layer (36);
a third reflective layer (37) on the third insulating layer (26) of the third sub-pixel (SP3);
a plurality of first electrodes (32) on the third insulating layer (26) of each of the first to third sub-pixels (SP1, SP2, SP3); and
a plurality of holes (H) penetrating the first to third insulating layers (22, 24, 26) of each of the first to third sub-pixels (SP1, SP2, SP3),
wherein the metal layer (M4) of each of the first to third sub-pixels (SP1, SP2, SP3) is electrically connected to the respective first electrode (32) of each of the first to third sub-pixels (SP1, SP2, SP3) through a respective hole (H) of the plurality of holes (H).

2. The display panel of claim 1, further comprising:
a first residual reflective layer (35a, 35b) on an upper portion of each of the first insulating layers (22) of the second and third sub-pixels (SP2, SP3);
a second residual reflective layer (36a, 36b) on an upper portion of each of the second insulating layers (24) of the first and third sub-pixels (SP1, SP3); and
a third residual reflective layer (37a, 37b) on an upper portion of each of the third insulating layers (26) of the first and second sub-pixels (SP1, SP2).

3. The display panel of claim 2, wherein the first to third residual reflective layers (35a, 35b; 36a, 36b; 37a, 37b) have sizes smaller than the sizes of the first to third reflective layers (35, 36, 37).

4. The display panel of claim 3, wherein the first to third residual reflective layers (35a, 35b; 36a, 36b; 37a, 37b) have different sizes depending on a wavelength band of light.

5. The display panel of any of claims 1 to 4, further comprising a via (V5) in each of the plurality of holes (H), and
wherein the respective metal layer (M4) is electrically connected to the respective first electrode (32) through the respective via (V5).

6. The display panel of any of claims 2 to 4, wherein each of the third residual reflective layer (37a, 37b) on an upper portion of the third insulating layer (26) of each of the first and second sub-pixels (SP1, SP2) and the third reflective layer (37) on an upper portion of the third insulating layer (26) of the third sub-pixel (SP3) has an upper surface in contact with the respective first electrode (32), and a lower surface electrically connected to the respective metal layer (M4) through a respective via (V5) in the respective hole (H) of the plurality of holes (H).

7. The display panel of any of claims 2 to 4, wherein each of the plurality of holes (H) includes a first hole (Ha) and a second hole (Hb),
wherein the first hole (Ha) penetrates the first insulating layer (22), and
wherein the second hole (Hb) penetrates the second insulating layer (24) and the third insulating layer (26).

8. The display panel of claim 7, wherein the first reflective layer (35-1) of the first sub-pixel (SP1) and the first residual reflective layer (35a-1, 35b-1) of the second and third sub-pixels are electrically connected to the respective metal layer (M4) through a respective via (V5a) in the first hole (Ha) of the respective hole (H) and electrically connected to the respective first electrode (32) through a respective via (V5b) in the second hole (Hb) of the respective hole (H).

9. The display panel of any of claims 2 to 4, wherein the third residual reflective layers (37a-2, 37b-2) of the first and second sub-pixels (SP1, SP2) and the third reflective layer (37-2) of the third sub-pixel (SP3) extend along the respective hole (H) of the plurality of holes (H) to be electrically connected to the respective metal layer (M4) of the plurality of metal layers (M4).

10. The display panel of claim 9, wherein the third residual reflective layer (37a-2, 37b-2) of the first and second sub-pixels (SP1, SP2) and the third reflective layer (37-2) of the third sub-pixel (SP3) have an upper surface of a portion in the third insulating layer (26) in contact with the respective first electrode (32), and a lower surface of a portion along the respective hole (H) in contact with the respective metal layer (M4).

11. The display panel of claim 9, wherein each of the plurality of holes (H) includes a first hole and a second hole, the first hole penetrates the first insulating layer (22), and the second hole penetrates the second insulating layer (24) and the third insulating layer (26).

12. The display panel of claim 11, wherein the first reflective layer (35-3) of the first sub-pixel (SP1) and the first residual reflective layer (35a-3, 35b-3) of the second and third sub-pixels (SP2, SP3) are electrically connected to the respective metal layer (M4) through a respective via (V5a) in the first hole of the respective hole, and are electrically connected to the respective first electrode (32) through a respective third residual reflective layer (37a-3, 37b-3) of the first and second sub-pixels (SP1, SP2) and a third reflective layer (37-3) of the third sub-pixel (SP3) along the second hole of the respective hole.

13. The display panel of claim 1, further comprising:
a second residual reflective layer (36a) on an upper portion of the second insulating layer (24) of the first sub-pixel (SP1); and
a third residual reflective layer (37a, 37b) on an upper portion of each of the third insulating layers (26) of the first and second sub-pixels (SP1, SP2).

14. The display panel of claim 1, further comprising a residual reflective layer (36a, 37a; 35a, 37b; 35b, 36b) formed in each sub-pixel (SP1, SP2, SP3),
wherein in each sub-pixel (SP1, SP2, SP3), the residual reflective layer (36a, 37a; 35a, 37b; 35b, 36b) is formed on the insulating layer different from a layer on which a corresponding reflective layer is formed.
